# EUROPEAN PATENT APPLICATION

(11) **EP 4 787 712 A1**
(43) Date of publication of application: **05.08.2026**
(21) Application number: 26154411.8
(22) Date of filing: 27.01.2026
(51) Int. Cl.: H03L 7/081, G06F 1/10, H04L 7/00

(54) **METHODS AND SYSTEMS FOR PROVIDING PROGRAMMABLE DELAY FOR SKEW ADJUSTMENT AND SYNCHRONIZATION**

(30) Priority: 31.01.2025 US 202519042211
(71) Applicant: Avago Technologies International Sales Pte. Limited, Singapore 768923 (SG)
(72) Inventor: Bu, Shi, Aliso Viejo, 92656 (US); Vasani, Anand J., Irvine, 92620 (US); Nidhi, Nitin, San Diego, 92127 (US); Kocaman, Namik Kemal, Irvine, 92618 (US)
(74) Representative: Dilg, Haeusler, Schindelmann Patentanwaltsgesellschaft mbH

(57) **Abstract**

The present invention generally relates to programmable delay generation techniques, and more specifically, to methods and systems for providing programmable delay for skew adjustment and lane synchronization in high-speed communication systems. A device for generating and aligning clock signals across multiple lanes in a high-speed communication system is disclosed. The device includes a controller providing control signals and a phase-locked loop generating a first clock signal. A first lane within a plurality of lanes comprises a first clock generator producing a first signal pair based on the first clock signal and a phase interpolator generating a second clock signal using the first signal pair and the control signals. The device further includes a circuit coupled to the lanes and configured to align their outputs for synchronization. There are other embodiments as well.

## Description

### FIELD OF INVENTION

The present invention is directed to electrical devices and methods thereof.

### BACKGROUND OF THE INVENTION

Generating programmable delays is useful for skew adjustment and lane-to-lane synchronization in high-speed communication systems, such as high-speed transceivers. These systems are critical in networking switches, physical layer transceivers, and other applications where precise timing is needed to maintain data integrity and minimize bit error rates (BER). Over the past, various types of delay-generation techniques have been proposed, but they are inadequate for reasons further explained below. New and improved systems and methods for providing programmable delay are desired.

### BRIEF DESCRIPTION OF THE DRAWINGS

Figure 1A is a simplified block diagram illustrating a four-lane transmitter 100 configured with programmable delay generation according to the embodiments of the present invention.
Figure 1B is a plot illustrating the alignment of lanes for transmitter 100 according to the embodiments of the present invention.
Figure 1C is a simplified timing diagram illustrating the TCA and skew adjustment process in a four-lane transmitter according to the embodiments of the present invention.
Figure 2A is a simplified block diagram illustrating a system 200 with 2T-PI-based delay generation according to the embodiments of the present invention, where the IQ clock generation is local inside each lane.
Figure 2B is a simplified block diagram illustrating a system with PI-based delay generation according to the embodiments of the present invention, where the IQ clock generation is local inside each lane.
Figure 3 is a simplified block diagram illustrating a system 300 with 4T-PI-based delay generation according to the embodiments of the present invention, where the IQ clock generation is local inside each lane.
Figure 4 is a simplified block diagram illustrating a quadrature clock generator 400 according to the embodiments of the present invention.
Figure 5 is a simplified block diagram illustrating a system 500 with IQ calibration according to the embodiments of the present invention.
Figure 6 is a simplified diagram illustrating a device 600 with PI-based programmable delay generation according to the embodiments of the present invention.
Figure 7 is a simplified diagram illustrating device 700 with the programmable delay generation according to the embodiments of the present invention, where the IQ clock generation is global, inside the PLL, and used by all lanes.
Figure 8 is a simplified diagram illustrating a receiver 800 with programmable delay generation according to the embodiments of the present invention, where the IQ clock generation is local for this case for illustration purposes.

### DETAILED DESCRIPTION OF THE INVENTION

The present invention generally relates to programmable delay generation techniques, and more specifically, to methods and systems for providing programmable delay for skew adjustment and lane-to-lane synchronization in high-speed communication systems. A device for generating and aligning clock signals across multiple transmitters or receivers in a high-speed communication system is disclosed. The device includes a controller providing control signals and a phase-locked loop generating a first clock signal. A first lane within a plurality of lanes comprises a first in-phase and quadrature-phase (IQ) clock generator producing a first signal pair based on the first clock signal and a phase interpolator generating a second clock signal using the first signal pair and the control signals. The device further includes a circuit coupled to the lanes and configured to align their outputs for synchronization. There are other embodiments as well.

As explained above, existing approaches for providing programmable delay have been inadequate. For example, high-speed communication systems often employ multi-lane architectures to achieve high data throughput. However, these architectures require precise synchronization of clock signals across the lanes to ensure reliable data transmission and reception. Various challenges need to be addressed in such systems. For example, a first challenge is skew adjustment, which involves compensating for timing mismatches between lanes caused by variations in signal transmission paths, board layouts, or process tolerances. These mismatches require fine-grained delay adjustments in the order of hundreds of femtoseconds to maintain signal alignment. Another challenge is transmitter clock alignment (TCA), which involves synchronizing the clock dividers for multiple lanes, in the context of transmitters and receiver clock alignment (RCA) in the context of receivers. Clock dividers in different lanes often start in random states upon system initialization, leading to phase mismatches between the lanes. TCA and/or RCA require programmable delays with a wider range, spanning multiple clock cycles (e.g., several nanoseconds), to achieve proper alignment.

In existing approaches, delay generation techniques are limited in addressing these timing challenges. CMOS delay cells, for example, generate delays by adjusting the RC time constant, but this approach may result in degraded signal integrity at high frequencies due to worsened rise and fall times and increased jitter. Tunable LC tanks used in current-mode logic (CML) delay generators can achieve operation at higher frequencies but suffer from signal gain loss and detuning when large delays are introduced. Polyphase filters (PPFs) are commonly used to generate in-phase (I) and quadrature-phase (Q) clock signals, but these circuits consume substantial power and require complex calibration to minimize mismatches between the I and Q signals.

Some existing architectures, such as those based on 1T, 2T, or 4T phase-locked loop (PLL) designs, present trade-offs between power consumption, noise performance, and design complexity. For instance, 1T PLLs paired with a divide-by-2 frequency divider (DIV2), which generates 2T IQ clock signals from the 1T PLL, and 2T phase interpolators (PIs), which need to be fed with the 2T IQ clock signals for delay generation, can support TCA but require high-frequency voltage-controlled oscillators (VCOs) with low-noise characteristics, resulting in increased power consumption and stringent design requirements. Alternatively, 2T PLLs paired with DIV2 and 4T PIs reduce the frequency demands on the VCO, but this configuration requires extensive calibration circuitry to address IQ mismatches, which increases area and design complexity. The terms "1T," "2T," and "4T" broadly refer to the clocking configurations and the timing relationships within the system. Specifically, "1T" indicates that the clock generator operates at the full rate of the signals to be transmitted or received by the transceivers, and the clock frequency is equal to the reciprocal of a unit interval (UI) of the communicated signals (e.g., 1T = 1UI), or in other words, the clock period is equal to a UI. In a "2T" architecture, the clocking system operates at half the frequency of a 1T architecture, effectively doubling the clock period to 2UI (2T) and enabling certain components, such as VCOs or phase interpolators, to achieve power savings and reduced noise at lower operating frequencies. Similarly, "4T" refers to an architecture where the clock operates at one-fourth the frequency of a 1T architecture, extending the clock period to 4T (or 4UI).

It is to be appreciated there is a need for a simple, low-power solution capable of addressing both skew adjustment and TCA and/or RCA requirements in multi-lane, high-speed communication systems. Existing designs often fail to provide a unified and efficient solution, particularly in scenarios that require both coarse and fine-granularity delay generation over wide ranges. It is to be appreciated that embodiments of the present invention provide a novel programmable delay generation system that combines a T-coil-based quadrature clock generator (Qgen) and a PI. The T-coil-based Qgen generates in-phase and quadrature-phase signals with sufficient precision and low power consumption, while the PI synthesizes arbitrary delays with fine granularity and a wide range. For example, the architecture enables the generation of both fine-grained skew adjustments (e.g., hundreds of femtoseconds per step with full 360-degree coverage) and large delays spanning multiple clock cycles by rotating the PI phase by more than 360 degrees. Furthermore, the invention simplifies PLL design, reducing power consumption and reference noise without requiring complex calibration circuitry. By leveraging the T-coil-based technology and programmable phase interpolation, the invention offers a robust, cost-effective solution for high-speed communication systems, reducing power and area consumption while enhancing overall system performance.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the present invention is not intended to be limited to the embodiments presented, but is to be accorded the widest scope consistent with the principles and novel features disclosed herein.

**In** the following detailed description, numerous specific details are set forth in order to provide a more thorough understanding of the present invention. However, it will be apparent to one skilled in the art that the present invention may be practiced without necessarily being limited to these specific details. In other instances, well-known structures and devices are shown in block diagram form, rather than in detail, in order to avoid obscuring the present invention.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of' or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

The term "delay" in the context of programmable delay generated by the PI can be either positive or negative. In other words, it can actually delay the clock in time (e.g., positive delay) or advance the clock in time (e.g., negative delay). For synchronization and skew adjustment purposes, the phases, delays, and skews among lanes are all in relative terms. When one lane is chosen as the reference lane, the purpose of synchronization and skew adjustment is to align all lanes' clocks and output streams to the reference lane. The programmable delays generated by the PIs during this process can either be positive or negative, since the PI phase can be rotated either way, to realize the final alignment of all lanes.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes a device, which comprises a controller configured to provide control signals; a phase-locked loop (PLL) coupled to a first clock generator, the PLL being configured to generate a first clock signal. The device further comprises a plurality of lanes comprising a first lane, the first lane comprising a first clock generator and a first phase interpolator. The first clock generator is configured to provide a first signal pair based at least on the first clock signal, the first phase interpolator is configured to generate a second clock signal based on first signal pair and the control signals. The device further comprises a circuit coupled to the plurality of lanes and configured to align outputs of the plurality of lanes.

Implementations may include one or more of the following features. The control signal comprises digital control codes. The first signal pair comprises a first in-phase clock signal and a first quadrature-phase clock signal. The first clock generator comprises a T-coil for generating a quadrature clock signal based on the first clock signal. The phase interpolator generates the second clock signal with programmable delay based on the first signal pair and the control signal. The first lane further comprises a divider configured to generate a third clock signal based on the second clock signal, the third clock being characterized by a lower clock frequency relative to the second clock signal. The first lane comprises a multiplexer configured to provide a data stream based on the second clock signal and an input data stream. The first lane comprises an analog-to-digital converter configured to provide a data stream based on the second clock signal and an input data stream. The plurality of lanes further comprises a second lane configured to provide a second signal pair. The circuit is configured to provide clock alignment by aligning phases of outputs of the plurality of lanes.

According to another embodiment, the subject technology provides a device that comprises a controller configured to provide control signals. The device further comprises a phase-lock loop (PLL) coupled to a first clock generator, the PLL being configured to generate a first clock signal, the first clock signal operating at a first frequency. The device further comprises a first clock generator configured to generate signal pairs for a plurality of lanes using the first clock signal, a first signal pair being characterized by a second frequency, the second frequency of the same as the first frequency. The device further comprises a phase interpolator being configured to generate a second clock signal with an adjusted phase/delay based on the signal pairs and the control signals. The device further comprises a divider configured to generate divided clock signals using the phase-adjusted second clock signals. The device further comprises a first multiplexer coupled to the divider, the first multiplexer being configured to provide a first data stream using an input data stream and the divided clock signals. The device further comprises a second multiplexer coupled to the phase interpolator and configured to provide a second data stream using the first data stream and the second clock signal.

Implementations may include one or more of the following features. The plurality of lanes comprises four lanes sharing the first clock generator, and each lane comprises its own phase interpolator. The device further comprises a synchronization circuit coupled to the divider and configured to provide a feedback signal to the controller. The controller is configured to generate the control signals using the feedback signal to adjust the phase interpolator. The first multiplexer comprises multiplexers operating at a frequency of the divided clock signals or the second clock signal. The device further comprises a digital-to-analog converter configured to generate analog signals based on the second data stream.

According to yet another embodiment, the subject technology provides a device that comprises a controller configured to provide control signals. The device further comprises a phase-locked loop (PLL) configured to generate a first clock signal, the first clock signal operating at a first frequency. The device further comprises a quadrature clock generator coupled to the PLL, the quadrature clock generator being configured to generate signal pairs. The device further comprises a dual-phase interpolator configured to receive the signal pairs and the control signals, the dual-phase interpolator being configured to generate phase-adjusted clock signals for the lane in which it is located. The device further comprises a divider coupled to the dual-phase interpolator, the divider being configured to generate divided clock signals using the phase-adjusted clock signals. The device further comprises a first multiplexer coupled to the divider, the first multiplexer being configured to provide a first data stream using an input data stream and the divided clock signals. The device further comprises a second multiplexer coupled to the phase interpolator and configured to provide a second data stream using the first data stream and the phase-adjusted clock signals. In various embodiments, the signal pairs comprise an in-phase signal and a quadrature-phase signal, the signal pairs being characterized by a second frequency, the second frequency being of the same as the first frequency. The dual-phase interpolator comprises a first interpolator and a second interpolator operating at a second frequency, the second frequency being a quarter of the reciprocal of a unit interval of the data being transmitted. The device further comprises a synchronization circuit coupled to the divider and configured to provide a feedback signal to the controller. The device further comprises a digital-to-analog converter coupled to a high-speed multiplexer and configured to generate analog signals based on the serialized high-speed data stream.

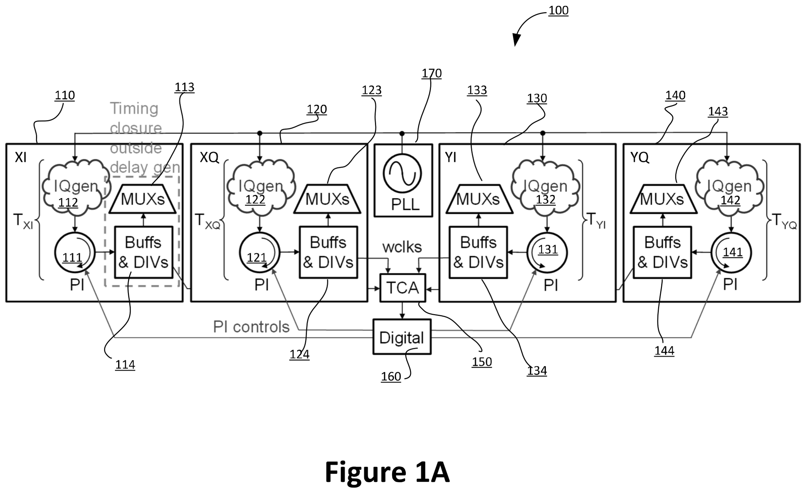

Figure 1A is a simplified block diagram illustrating a four-lane transmitter 100 configured with programmable delay generation according to embodiments of the present invention. This diagram is merely an example, which should not unduly limit the scope of the claims. One of ordinary skill in the art would recognize many variations, alternatives, and modifications. For example, transmitter 100 is configured with a phase alignment mechanism across its lanes using a combination of clock generation, phase interpolation, and clock alignment circuitry. As shown, transmitter 100 includes four lanes: lane XI 110, lane XQ 120, lane YI 130, and lane YQ 140 with each having a total delay from the clock path of T_{XI}, T_{XQ}, T_{YI}, and T_{YQ}, respectively, with respect to the PLL 170. For example, upon system initialization, each lane's frequency dividers 114, 124, 134, and 144 will have random, unknown phase states. Multiplexers 113, 123, 133, and 143 driven by these dividers are clocked with different phases, resulting in each lane serializing the digital data to be transmitted with misalignments, which scrambles the final output signals of the entire system of four lanes. Due to process and path variations, the clock distributions within each lane have similar but different delays (e.g., T_{XI} ≠ T_{XQ} ≠ T_{YI} ≠ T_{YQ}), resulting in skewed transmitter output streams and distorting the constellation of the transmitted signals of the entire system of four lanes. The subject technology configures each lane with components to generate, adjust, and utilize clock signals by creating programmable delays within the clock paths (e.g., adjusting T_{X1}, T_{XQ}, T_{YI}, and T_{YQ}) to align the phase states of dividers 114, 124, 134, and 144 and remove clock skews among lanes for data transmission.

As an example, lane XI 110 includes a first clock generator. The term "clock generator" may refer to any circuit or system configured to generate, derive, or modify clock signals. This may include, but is not limited to, phase-locked loops (PLLs), quadrature clock generators (Qgen), in-phase and quadrature (IQ) signal generators (IQgen), delay-locked loops (DLLs), frequency dividers, and/or the like. For example, the first clock generator (e.g., IQgen 112) may be used to generate a first signal pair comprising an in-phase clock signal and a quadrature-phase clock signal. In a specific implementation, IQgen 112 may be implemented with a T-coil to generate quadrature signals, thereby allowing signal generation with minimal phase mismatches. As used herein, the term "T-coil" may refer broadly to a configuration of two or more inductors coupled in series to introduce a controlled delay. This may include both loosely and strongly coupled implementations and is not limited to conventional T-coil structures used in other applications or specific schematic representations described in this disclosure. For example, the signal pair-as provided by IQgen 112-is used by a first phase interpolator PI 111, which adjusts the phase of the clock signal based on digital control codes received from a controller. The phase-adjusted clock signal is subsequently used by a multiplexer MUX 113 to serialize an input data stream, producing a data stream synchronized with the clock signal. For example, buffers and dividers (e.g., Buffs & DIVs 114) in lane XI 110 condition and process the clock signals, including generating additional clock signals with reduced frequencies as needed for synchronization and timing adjustments.

In some embodiments, lane XQ 120 operates similarly, with its own IQ clock generator (e.g., IQgen 122), phase interpolator (e.g., PI 121), multiplexer 123, and buffers and dividers 124. For example, the clock signals generated by IQgen 122, which are based on a clock signal from the phase-locked loop (e.g., PLL 130), are phase-adjusted using PI 121 and digital control codes. Lane YI 130 and lane YQ 140 are configured according to a similar structure, with IQ clock generators (e.g., 132 and 142), phase interpolators (e.g., 131 and 141), multiplexers (e.g., 133 and 143), and buffers and dividers (e.g., 134 and 144).

PLL 130, in various implementations, provides a first clock signal, which serves as the reference clock for all lanes. The PLL, for example, is coupled to the IQ clock generators in each lane and provides a stable, low-noise clock signal. It is to be appreciated that by operating at a lower frequency compared to traditional designs, PLL 130 may reduce power consumption and minimize reference noise, contributing to the overall efficiency of the transmitter.

A transmitter clock alignment (TCA) circuit 150 is configured to detect phase alignment across the lanes. For example, the TCA circuit interacts with the dividers and clock signals in each lane by receiving and analyzing the outputs of the clock dividers (e.g., word clocks (wclks)), allowing to correct timing mismatches that may arise during initialization or due to process and path variations. This alignment process is facilitated by controller 160, which provides control signals to the phase interpolators in each lane. For example, TCA circuit 150 and controller 160 together form a feedback loop. Controller 160 generates phase adjustment codes based on system requirements and feedback from TCA circuit 150. After the completion of TCA, the clock divider state randomness among lanes upon system initialization is eliminated, but each lane may still experience small skews among each other as a result of mismatches among the clock paths that drive the multiplexers. A skew adjustment process can be further performed to remove the skews among the outputs of the lanes by adjusting the PI control signals.

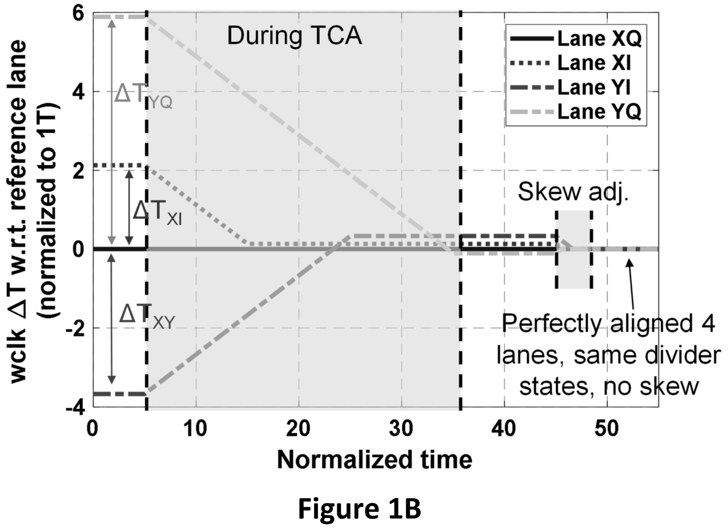

Figure 1B is a plot illustrating the alignment of lanes for transmitter 100. For example, alignment can be achieved through TCA circuit 150, which ensures that all lanes are synchronized to eliminate the clock divider state randomness upon system initialization and maintain consistent timing across the system. The horizontal axis of the plot represents normalized time, while the vertical axis represents the word clock phase difference Δ*T* with respect to a reference lane, normalized to one UI (or 1T). Initially, the clock phases of the four lanes-lane XI 110, lane XQ 120, lane YI 130, and lane YQ 140-are misaligned, as shown by the differing Δ*T* values for each lane. For example, lane XI begins with a phase offset of approximately +2T, while lane YQ starts at +6T. Similarly, lane XQ and lane YI exhibit phase offsets of 0T and -4T, respectively. Lane XQ has a phase offset of 0T because it is used as the reference lane in this example. The integer portion of ΔT comes from misaligned divider states upon system initialization, and the fractional portion comes from the clock skew of each respective lane (irrespective of the divider states), such as the difference among T_{XI}, T_{XQ}, T_{YI}, and T_{YQ} in Figure 1A.

During the TCA process, the system adjusts the clock phases of each lane to bring them into alignment. This adjustment is achieved by controlling the phase interpolators in each lane using digital control codes generated by the controller. As the TCA and controller circuits operate, the phase offsets gradually converge toward zero for all lanes. This convergence is observed in the plot, where the trajectories of ΔT for each lane move toward the zero line over time. Following the completion of the TCA process, at approximately 40 normalized time units, all four lanes reach alignment. The clock dividers in each lane are synchronized to the same state, ensuring consistent and coordinated operation of the transmitter. In this state, the system function is guaranteed, but the performance is subject to the residual skew of the clock paths, which may lead to a distorted constellation of the signals of the entire four-lane system.

After achieving clock alignment, the system proceeds to perform skew adjustment, as shown in the region beyond the TCA process in the plot. The skew adjustment process compensates for any residual timing mismatches caused by variations in signal paths or board layout, further refining the alignment. By the end of the adjustment phase, all four lanes remain aligned in divider states or phases, with no observable skew between their outputs. At this point, the clock signals across all lanes exhibit the same phase, as indicated by the overlapping trajectories of ΔT at the zero line. The system performance is now guaranteed and there will be no distortion in the signal constellation.

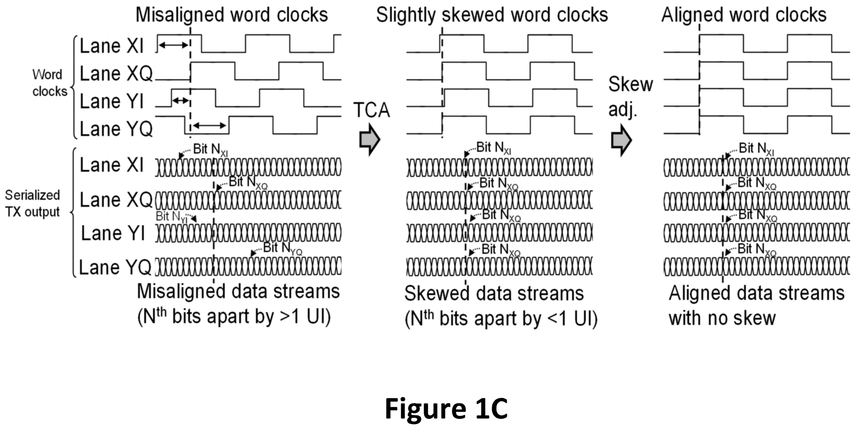

Figure 1C is a simplified timing diagram illustrating the TCA and skew adjustment process in a four-lane transmitter according to the embodiments of the present invention. This diagram is merely an example, which should not unduly limit the scope of the claims. One of ordinary skill in the art would recognize many variations, alternatives, and modifications.

Initially, the word clocks of the lanes (e.g., lane XI 110, lane XQ 120, lane YI 130, and lane YQ 140) are misaligned due to random initial states of the dividers and mismatches in clock path delays, resulting in skewed data streams where bits from different lanes arrive more than one UI apart. During the TCA phase, the divider state mismatches between lanes are corrected by the TCA circuit. This phase alignment ensures the word clocks are synchronized across lanes, reducing timing discrepancies to less than one UI. However, minor skews may remain due to residual clock path mismatches. Following TCA, a skew adjustment process may applied to correct the remaining timing mismatches. The phase interpolators are further adjusted to remove the residual skews, resulting in fully aligned word clocks and data streams.

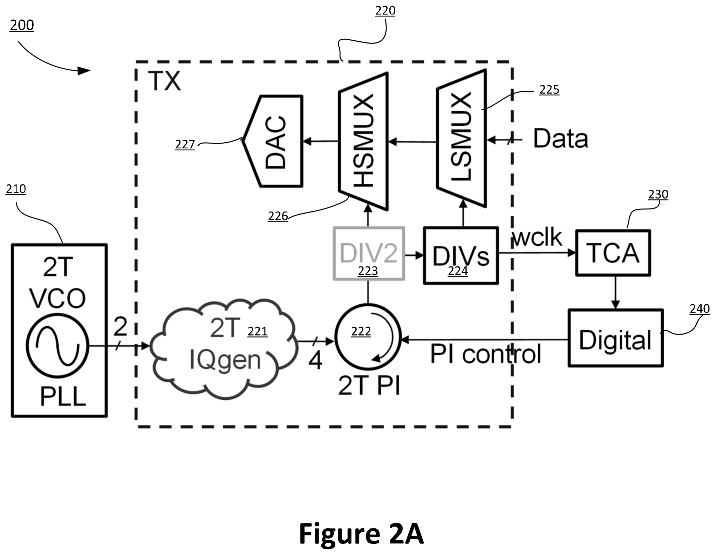

Figure 2A is a simplified block diagram illustrating a system 200 with 2T-PI-based delay generation according to embodiments of the present invention. This diagram is merely an example, which should not unduly limit the scope of the claims. One of ordinary skill in the art would recognize many variations, alternatives, and modifications.

In a multi-lane transmitter system 200, transmitter 220, which is one lane of the multi-lane transmitter system with other lanes omitted in the figure for ease of description, is coupled to a 2T PLL 210, which serves as the primary clock source. PLL 210 generates a first clock signal that operates at a first frequency that is equal to the reciprocal of 2UI (or equivalently, 2T). This clock signal is provided to a 2T IQ clock generator (e.g., IQgen 221), which generates a first signal pair consisting of an in-phase clock signal and a quadrature-phase clock signal. The frequency of the first signal pair is identical to the first clock signal's frequency. The I and Q signals are subsequently supplied to a 2T phase interpolator 222. Because a 2T PI 222 needs both in-phase clock signal and quadrature-phase clock signal at 2T frequency to operate, the 2T PLL 210 and 2T IQgen 221 combination avoids the need in existing approaches of running the PLL at 1T frequency (twice of 2T frequency) followed by a DIV2 to generate in-phase clock signal and quadrature-phase clock signal at 2T frequency to be used by the PI. This allows for lower PLL operating frequencies and reduces power consumption.

For example, phase interpolator 222 receives the first signal pair (with I and Q signals) from the IQgen and adjusts the phase of the clock signal based on control signals generated by a digital controller 240. The adjusted clock signal, referred to as the second clock signal, is then used for timing alignment and synchronization across the transmitter. A divider 224 coupled to the phase interpolator generates additional clock signals with reduced frequencies for use by downstream components, including multiplexers. Depending on the implementations, an optional DIV2 block 223 may be used to enable compatibility with quarter-rate DACs or lower-frequency components.

Transmitter 220 further includes two multiplexers: a high-speed multiplexer (HSMUX 226) and a low-speed multiplexer (LSMUX 225). HSMUX 226 receives parallel input data streams from the LSMUX 225 and serializes them into a high-speed data stream, synchronized with the second clock signal provided by the PI. LSMUX 225 operates at the frequency of the divided clock signals from the divider and is used to serialize lower-speed data streams. A digital-to-analog converter (e.g., DAC 227) is coupled to the high-speed multiplexer. DAC 227 converts the high-speed serialized data stream into an analog signal suitable for transmission over the physical medium.

Synchronization of transmitter 200 is provided by transmitter clock alignment (TCA) circuit 230, which works in conjunction with the divider and digital controller. TCA circuit 230 ensures that the clock phases across the lanes are aligned and that the clock dividers are in the same state. Feedback signals from TCA circuit 230 are sent to digital controller 240, which generates control signals to adjust the phase interpolator as necessary. This feedback mechanism allows for dynamic adjustments and compensation for timing mismatches caused by process variations or clock path differences.

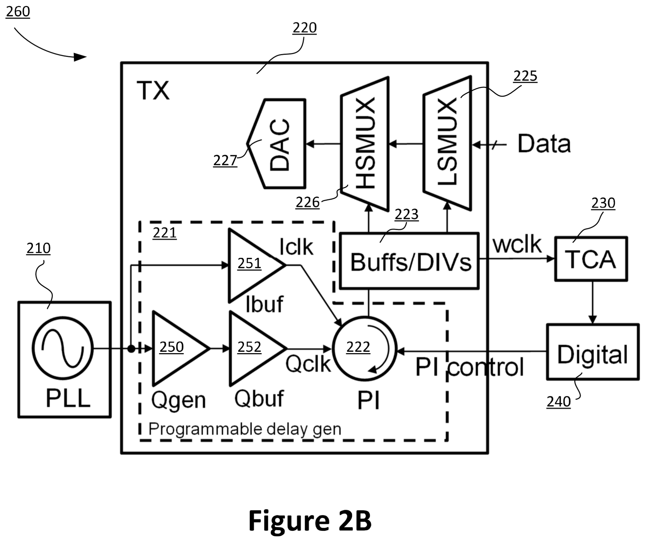

Figure 2B is a simplified block diagram illustrating a system 260 with PI-based delay generation according to the embodiments of the present invention, where the IQ clock generation is local inside each lane. In various implementations, similar to system 200 of Figure 2A, system 260 includes at least one of PLL 210, and transmitter 220, which is one lane of the multi-lane transmitter system with other lanes omitted in the figure for ease of description, comprising clock generator 221, phase interpolator 222, divider 223, LSMUX 225, HSMUX 226, DAC 227, TCA circuit 230, digital controller 240, and/or the like.

In various implementations, clock generator 221 may include a quadrature clock generator (e.g., Qgen 250) configured to generate a quadrature-phase clock signal (e.g., Qclk) based on the clock signal provided by PLL 210. The in-phase clock signal (e.g., Iclk) may be derived from the PLL output without additional processing by Qgen 250. Both the Qclk and Iclk signals may be amplified and conditioned by IQ buffers, such as an I buffer (e.g., Ibuf 251) and a Q buffer (e.g., Qbuf 252), ensuring adequate signal strength and minimizing noise for subsequent processing. In some examples, the outputs of the IQ buffers (e.g., Iclk and Qclk) are provided to the phase interpolator 222, which adjusts the phase of the clock signal based on control signals received from digital controller 240.

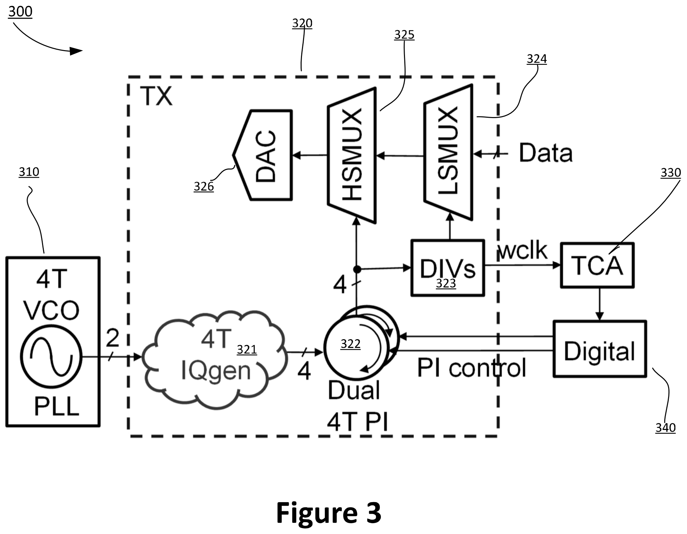

Figure 3 is a simplified block diagram illustrating a system 300 with 4T-PI-based delay generation according to embodiments of the present invention. This diagram is merely an example, which should not unduly limit the scope of the claims. One of ordinary skill in the art would recognize many variations, alternatives, and modifications.

System 300 includes a 4T PLL 310, which generates a first clock signal operating at a first frequency that is equal to the reciprocal of 4UI (or equivalently, 4T). For example, the first clock signal serves as the reference clock for the IQ clock generator (e.g., 4T IQgen 321). IQgen 321 provides signal pairs that include an in-phase signal (I) and a quadrature-phase signal (Q), characterized by a second frequency that is identical to the first frequency. For example, the PLL runs at 4T frequency, which is a quarter of that of a PLL running at 1T frequency and half of that of the 2T PLL 210 in Figure 2. The 4T architecture further allows for reduced operating frequencies to improve power efficiency and noise performance.

The signal pairs provided by the IQgen 321 are supplied to a dual-phase interpolator 322, which comprises two phase interpolators operating in parallel. In various embodiments, dual-phase interpolator 322 receives control signals from digital controller 340 to adjust the phase of the clock signals. The phase adjustment results in phase-aligned clock signals, referred to as phase-adjusted clock signals, which are used to synchronize the lanes and support precise timing requirements for data serialization. Divider 323 is coupled to dual-phase interpolator 322 to generate divided clock signals derived from the phase-adjusted clock signals. These divided clock signals are used for lower-frequency operations, such as driving the low-speed multiplexer LSMUX 324. LSMUX 324 serializes an input data stream using the divided clock signals to produce a serialized output data stream at a lower rate. System 300 also includes high-speed multiplexer HSMUX 325, which operates at the higher frequency of the phase-adjusted clock signals from the dual-phase interpolator. The HSMUX 325 serializes data streams from the LSMUX 324 into a high-speed output data stream, synchronized with the phase-adjusted clock signals. The high-speed data stream is then provided to DAC 326, which converts the serialized data into an analog signal for transmission over the physical medium. DAC 326 operates in synchronization with the HSMUX 325 to ensure high signal integrity.

To achieve lane-to-lane synchronization, the system utilizes TCA circuit 330. TCA circuit 330 uses the output of divider 323 and other components to align the clock phases across the lanes. For example, a feedback mechanism is implemented, wherein the TCA circuit provides feedback signals to digital controller 340. Based on the feedback signals, digital controller 340 adjusts the phase interpolator settings to maintain precise alignment across all lanes.

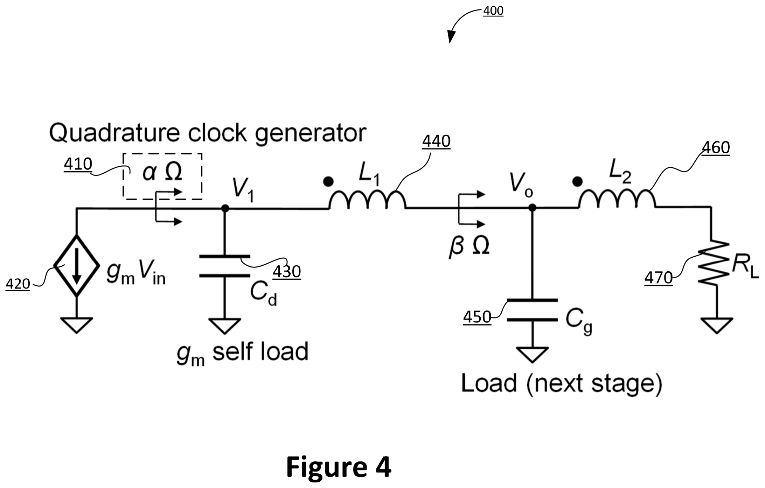

Figure 4 is a simplified block diagram illustrating a quadrature clock generator (Qgen) 400 according to embodiments of the present invention. This diagram is merely an example, which should not unduly limit the scope of the claims. One of ordinary skill in the art would recognize many variations, alternatives, and modifications. For example, quadrature clock generator 400 may be employed in systems such as the transmitter 100 in Figure 1 to enable precise skew adjustment and synchronization across multiple lanes.

Quadrature clock generator 400 includes driver 420, which can be implemented as a differential pair in a CML circuit, with a transconductance (gm) stage that converts the input voltage Vin into a differential current. For ease of description, a single-ended diagram is shown for quadrature clock generator 400 in lieu of a differential one. It is to be appreciated that in practical applications, the circuit may be configured as fully differential, pseudo-differential, or single-ended, depending on the implementation. The load presented to driver 420 is equivalent to a single capacitive load Cg 450 from the next stage that the quadrature clock generator 400 drives. In this example, the next stage can be a quadrature clock buffer and its load presented to the quadrature clock generator 400 is a capacitor Cg. The T-coil, consisting of inductors 440 and 460, coupled to a load resistor 470, the capacitance Cd 430 from the driver 420 itself, and Cg upon proper design of each element's values can generate a 90-degree phase shift required for quadrature signals with a voltage gain with respect to the input signal. The in-phase clock can be derived from the input of the quadrature clock generator 400, Vin, directly, while the quadrature-phase output Vo is taken from T-coil. Both the voltage gain and phase shift of the output signal with respect to the input in-phase clock can be designed by adjusting the values of the active or passive elements, including gm, Cd, Cg, load resistor 470, and inductors 440 and 460. For applications where a quadrature-phase clock with the same signal swing as the in-phase clock is needed, the phase shift and voltage gain can be designed as 90 degrees and 1 V/V, respectively. For other applications where a different phase shift or signal swing are needed, these elements' values can be changed to accommodate the design goal.

It is to be appreciated that by replacing traditional RC- or LC-loaded CML delay generators with the T-coil architecture, the quadrature clock generator achieves substantial power savings and improved signal integrity for the purpose of generating a quadrature-phase clock with a large signal swing based on an in-phase clock from the PLL. It is a single-stage circuit with one active component, which is the gm stage, and provides a voltage gain that can be lower than, equal to, or higher than 1 V/V. Because only the active component consumes power, which the Qgen has only one, and the phase shift is achieved by using a passive network, its power consumption is low. Both traditional RC- or LC-loaded CML buffers are not able to provide a 90-degree phase shift and a large signal swing simultaneously in a single stage. Many stages with each having at least one active component are needed to reach a 90-degree phase shift with usable output signal swing, making them consume much higher power than the present invention. In addition to low power consumption, it is also to be appreciated that the single-stage CML architecture of the quadrature clock generator using a passive network generates very low noise and can operate at high frequencies, making it suitable for high-speed communication systems requiring robust timing control, such as serializers/deserializers (SerDes) and optical transceivers.

IQgen can be implemented using the quadrature clock generation 400. Because the input of the Qgen 400 is already an in-phase clock signal, a simple method of implementing an IQgen is taking the input and output of the quadrature clock generation 400 as the in-phase and quadrature-phase clocks, respectively. Optional buffers can be added at the input and/or output of the Qgen 400 to improve signal quality. This is merely an example, which should not unduly limit the scope of the claims. One of ordinary skill in the art would recognize many variations, alternatives, and modifications.

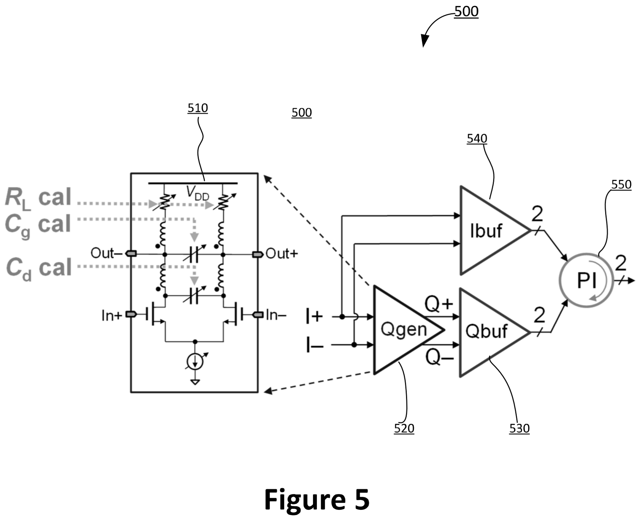

Figure 5 is a simplified block diagram illustrating a system 500 with the quadrature clock generator (Qgen 520) in the present invention with optional IQ calibration according to embodiments of the present invention. This diagram is merely an example, which should not unduly limit the scope of the claims. One of ordinary skill in the art would recognize many variations, alternatives, and modifications. Quadrature clock generator 520 is the core component of system. An exploded view of quadrature clock generator 520 shows a differential circuit topology with a transconductance stage (gm) as the driver for the T-coil to generate the quadrature-phase clock signal, whereas the input of the Qgen 520 is used as the in-phase clock signal. The T-coil-based architecture reduces power consumption and provides a 90° phase shift between the I and Q signals. The circuit includes calibration paths for fine-tuning critical parameters, including load resistance R_{L}, equivalent gate capacitance C_{g}, and equivalent drain capacitance C_{d}. Depending on the implementation, these parameters can be calibrated dynamically during system operation to optimize gain, delay, and phase alignment, thus compensating for variations caused by process or temperature changes.

The input and output of the quadrature clock generator, including differential I and Q signals, are coupled to IQ buffers 540 and 530. The I buffer (e.g., Ibuf 540) and Q buffer (e.g., Qbuf 530) amplify their respective signals to ensure consistent amplitude levels and low distortion. For example, these buffers may equalize the amplitudes of the I and Q signals, mitigating imbalances that might affect the downstream phase interpolation process. This equalization improves the performance of the phase interpolator 550 by providing it with clean, matched input signals. Depending on the system specifications, the IQ buffers 540 and 530 may be removed to further save power. Phase interpolator 550 uses the differential I and Q signals to generate phase-adjusted clock signals as required by the application. As explained above, PI 550 is controlled by digital codes that determine the desired phase shift, enabling precise timing adjustments across multiple lanes in the transmitter system.

The optional calibration capabilities of the quadrature clock generator can further refine the accuracy of the achieved fine-grained phase control. The calibration paths enable foreground or background tuning of the generator's components to adapt to changing operating conditions. For instance, tuning R_{L} C_{g}, and C_{d} influences the phase and amplitude characteristics of the Qgen output signals. These adjustments ensure that the IQ clock signals maintain high fidelity and good matching between each other even in demanding environments, such as multi-lane communication systems operating at frequencies exceeding 20 GHz.

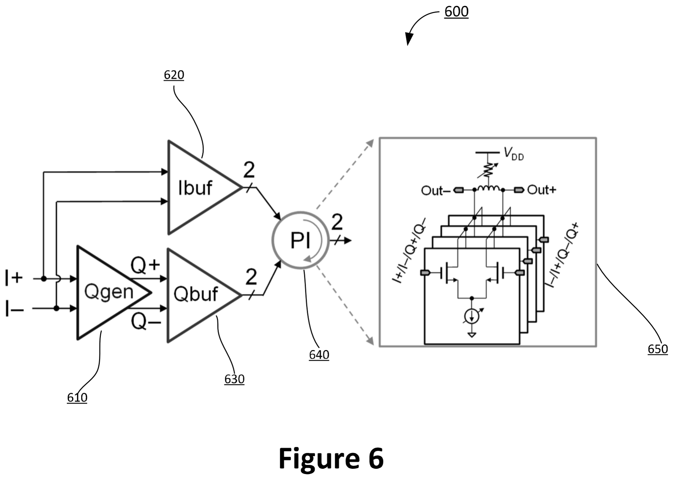

Figure 6 is a simplified diagram illustrating a device 600 with PI-based programmable delay generation according to embodiments of the present invention. This diagram is merely an example, which should not unduly limit the scope of the claims. One of ordinary skill in the art would recognize many variations, alternatives, and modifications.

Device 600 includes quadrature clock generator (e.g., Qgen 610) that produces two differential clock signals: an in-phase signal pair (I+ and I-) and a quadrature-phase signal pair (Q+ and Q-). For example, the quadrature-phase signal pair is generated using a T-coil-based quadrature clock generation architecture, ensuring low power consumption and high signal integrity. Qgen 610 provides stable phase-shifted clock signals that serve as the input to the subsequent buffering and interpolation stages. The differential clock signals from the the input and output of the Qgen are amplified by IQ buffers, including the I buffer (e.g., Ibuf 620) and Q buffer (Qbuf e.g., 630). For example, these buffers amplify the I and Q signal pairs to ensure that the signals have sufficient amplitude for downstream processing. Buffers, in various implementations, equalize the amplitude levels of the I and Q signals to mitigate any imbalances caused by circuit mismatches or variations in the Qgen. Phase interpolator (i.e., PI 640) receives the differential clock signals from the IQ buffers and is controlled by digital input codes to generate a delayed or phase-adjusted clock signal. The PI operates by interpolating between the I and Q clock signals, producing an output clock signal with a phase that can be adjusted across a full 360-degree range. Block 650 provides an exploded view of the internal structure of PI 640. As an example, PI 640 is implemented using a current-mode logic (CML) architecture, which includes multiple differential pairs driven by the input clock signals (I+/- and Q+/-) of the PI 640. The configuration of the tail currents of these differential pairs allows for the blending of the in-phase and quadrature-phase signals to synthesize the desired phase output. The load network, powered by V_{DD}, is tuned to maintain high signal fidelity while minimizing phase noise and jitter in the output signal.

The circuits in Figures 5 and 6 are the exploded views of the combination of the IQgen and PI in Figures 1A, 2A, and 3, which provide the IQ signal pairs to the PI input based on the signals at the input and output of the Qgen. This is merely an example, which should not unduly limit the scope of the claims. One of ordinary skill in the art would recognize many variations, alternatives, and modifications.

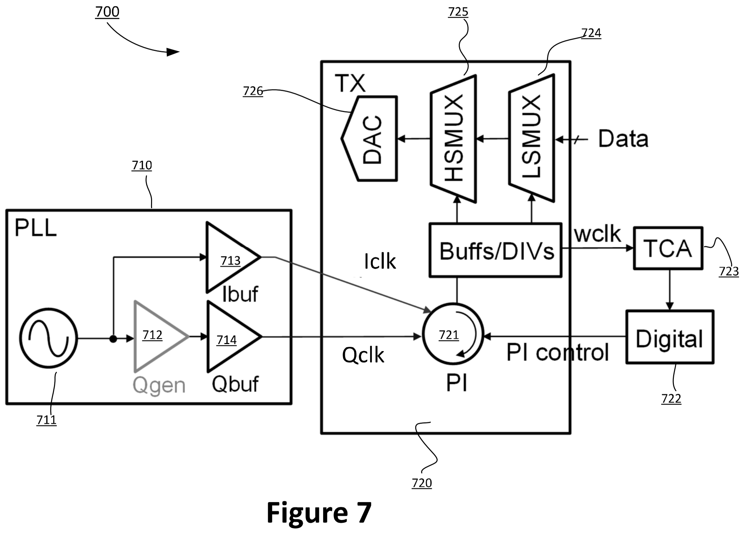

Figure 7 is a simplified diagram illustrating device 700 with the programmable delay generation according to embodiments of the present invention. This diagram is merely an example, which should not unduly limit the scope of the claims. One of ordinary skill in the art would recognize many variations, alternatives, and modifications.

PLL block 710 includes clock generator 711 (e.g., a VCO) that produces a primary clock signal. This signal is fed into the quadrature clock generator Qgen 712, Ibuf 713, and Qbuf 714, which generate two differential quadrature clock signals: an in-phase clock signal pair (Iclk: I+ and I-) and a quadrature-phase clock signal pair (Qclk: Q+ and Q-) that are fed to transmitter 720, which is one lane of the multi-lane transmitter system with other lanes omitted in the figure for ease of description. Qgen 712, as an example, is configured to operate efficiently using a T-coil-based architecture, ensuring low power consumption and 90-degree phase shifts between the I and Q clock signals. It is appreciated that the Qgen operates at the same frequency of the PI in the transmitter 720 and does not divide the frequency of the clock generator 711 by two, resulting in VCO running at the same frequency as the PI instead of twice that of the PI, helping the PLL save power and improve its noise performance.

The differential Iclk and Qclk signals are passed to the IQ buffers, which include I buffer (i.e., Ibuf 713) and Q buffer (i.e., Qbuf 714). For example, buffers 713 and 714 amplify the respective clock signals to achieve adequate signal strength while maintaining balanced amplitude levels. The buffering ensures that the PI operates with high-quality input signals, minimizing errors caused by amplitude or phase mismatches.

Because the Qgen 712 and the following IQ buffers 713 and 714 are placed inside the PLL instead of inside each transmitter lane, the Iclk and Qclk signals can be fed to multiple transmitter lanes. This enables further power saving and each lane is still capable of synthesizing its programmable delay using its PI. For example, the amplified Iclk and Qclk signals are provided to the phase interpolator (i.e., PI 721) in the transmitter block 720. The PI is a critical component for generating programmable delays. It interpolates between the Iclk and Qclk inputs based on control signals provided by digital controller 722. The controller uses these digital control codes to set the desired phase shift, enabling the PI to output a phase-adjusted clock signal with a programmable delay.

The phase-adjusted clock signal output by PI 721 is used by several components in the transmitter. A buffers/dividers block 724 uses the PI output to generate the word clock signals (e.g., wclk) for TCA and other buffered or divided clocks for data serialization. The buffered or divided clock signals are supplied to the high-speed multiplexer (i.e., HSMUX 725) and low-speed multiplexer (i.e., LSMUX 724). HSMUX 725 serializes high-speed data streams, and the LSMUX 724 handles lower-speed data serialization. The system includes TCA circuit 723 that ensures all lanes in the transmitter are synchronized. The TCA compares the phase of the wclk signals across multiple lanes and provides feedback to digital controller 722 to adjust the PI settings dynamically in each lane, compensating for clock divider initial state mismatches. Skews among the lanes are compensated after TCA by further adjusting PI controls.

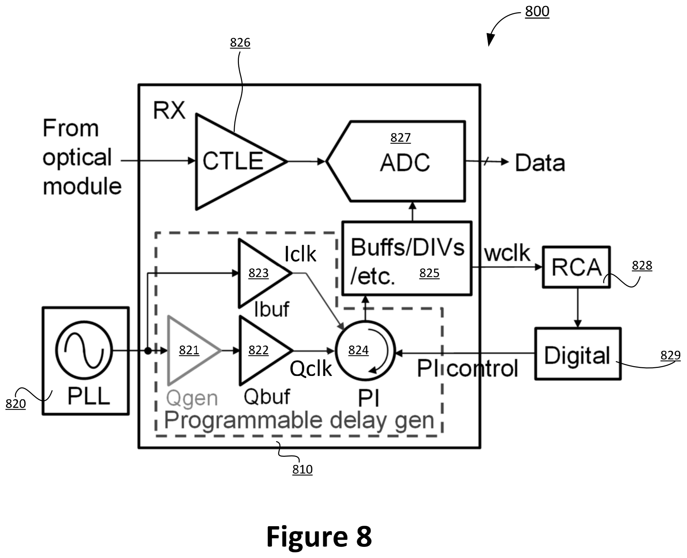

Figure 8 is a simplified diagram illustrating a receiver 800 with programmable delay generation according to embodiments of the present invention. This diagram is merely an example, which should not unduly limit the scope of the claims. One of ordinary skill in the art would recognize many variations, alternatives, and modifications.

Receiver system 800 includes PLL 820 that generates a primary clock signal. The receiver is an example of one lane in a multi-lane system, all driven by PLL 820, where other lanes of receivers are omitted in the figure for ease of description. This clock signal is provided to the quadrature clock generator (i.e., Qgen 821), which produces two differential clock signal pairs: an in-phase clock signal pair and a quadrature-phase clock signal pair at its input and output, respectively. Qgen 821, as an example, may utilize a T-coil-based architecture to achieve high fidelity and low power consumption while maintaining a 90° phase shift between the in-phase and quadrature-phase clock signals.

The two differential clock signal pairs are amplified by IQ buffers, which include the I buffer (i.e., Ibuf 823) and Q buffer (i.e., Qbuf 822). These buffers ensure the clock signals have sufficient amplitude for downstream processing while maintaining balanced signal levels. The buffered signal pairs (Iclk: I+ and I- and Qclk: Q+ and Q-) signals, which have a phase difference of 90°, are provided to the phase interpolator (i.e., PI 824), which performs programmable delay generation. PI 824 receives control signals (e.g., PI control) from digital controller 829 and interpolates between the Iclk and Qclk signals to produce a phase-adjusted clock signal. This phase-adjusted signal enables precise delay generation and synchronization across multiple lanes.

Programmable delay generation block 810, which includes the Qgen 821, IQ buffers 823 and 824, and PI 824, outputs phase-adjusted clock signals to buffers/dividers block 825. This block generates the word clock signals (e.g., wclk) that are synchronized for the receiver's operations. The wclk signals drive the receiver clock alignment (RCA) circuit 828, which ensures that all lanes of receivers are aligned. The RCA circuit 828 compares the phases of wclk clock signals across lanes and provides feedback to the digital controller 829 to adjust the PI settings, aligning all receiver lanes. After RCA, skew adjustment may follow and it removes residual timing mismatches among the received signals from all lanes, by rotating the PI phase further.

In the data path, the received electrical signals from the optical module are first processed by a continuous-time linear equalizer (CTLE) 826 to compensate for channel losses and improve signal integrity. The equalized signals are converted into digital form by an analog-to-digital converter (ADC) 827, which operates in synchronization with the clock signals generated by the programmable delay block and downstream dividers, buffers, and other circuits (Buffs/DIVs/etc. 825). The ADC outputs digital data for further processing. There are other embodiments as well.

It is to be appreciated that embodiments of the present invention provide numerous advantages in terms of circuit design, system performance, and product implementation, making it highly beneficial for high-speed data communication systems.

From a circuit perspective, the use of current-mode logic (CML) IQ buffers and PI simplifies design and verification processes by leveraging commonly used components in high-speed wireline transceivers. The quadrature clock generator, based on a T-coil architecture, can be conveniently implemented and reused, as it primarily involves a single sub-block requiring specialized attention, which is the T-coil. This approach reduces design complexity, power consumption, and form factor compared to conventional delay-locked loops or polyphase filters. Additionally, the T-coil-based design offers great flexibility, allowing for manipulation of gain and phase (e.g., non-90-degree delays if required) without compromising power efficiency. The absence of CMOS sections ensures suitability for high-speed, low-jitter applications above 20 GHz, while optional foreground or background calibration can be implemented to further refine IQ accuracy if needed.

From a system standpoint, the invention provides a solution for lane-to-lane synchronization and skew adjustment with fine resolution and a wide range, meeting the stringent requirements of modern high-speed communication systems. It reduces reliance on stringent PLL designs, leading to significant power savings and jitter improvements. The invention is versatile, supporting both half-rate and quarter-rate transmitter DAC architectures as well as receiver systems. For half-rate DACs, no additional calibration is needed, while for quarter-rate DACs, IQ errors can be corrected digitally through PI control codes. Similarly, in receiver implementations, the system eliminates the need for high-rate PLLs or complex delay-locked loops (DLLs), further reducing power and area requirements.

In various implementations, skew adjustment can be performed outside the multiplexer timing design, streamlining the overall timing design process. The global clock distribution is simplified, with the invention implemented inside each lane, capable of sending only the I-clock (instead of full IQ clocks) to each lane to save power and area, and minimize coupling issues. This localized Qgen architecture minimizes power and area overheads, addressing key challenges in PLL, global clocking, and multiplexer design. Alternatively, when implemented inside PLL, the global clock distribution is similar to existing approaches, but only one set of IQgen is needed to support multiple lanes, significantly further saving power and area.

From a product perspective, the invention reduces area and power consumption while enabling a wide skew correction range. This capability is critical for tolerating excessive skew introduced by packaging, board traces, or other system-level constraints. There are many other benefits as well.

While the above is a full description of the specific embodiments, various modifications, alternative constructions and equivalents may be used. Therefore, the above description and illustrations should not be taken as limiting the scope of the present invention which is defined by the appended claims.

## Claims

1. A device comprising:
a controller configured to provide control signals;
a phase-locked loop, PLL, coupled to a first clock generator, the PLL being configured to generate a first clock signal;
a plurality of lanes comprising a first lane, the first lane comprising a first clock generator and a first phase interpolator, the first clock generator being configured to provide a first signal pair based at least on the first clock signal, the first phase interpolator being configured to generate a second clock signal based on first signal pair and the control signals; and
a circuit coupled to the plurality of lanes and configured to align outputs of the plurality of lanes.

2. The device of claim 1, wherein
the control signal comprises digital control codes.

3. The device of claim 1 or 2, wherein
the first signal pair comprises a first in-phase clock signal and a first quadrature-phase clock signal.

4. The device of any one of the claims 1 to 3, wherein
the first clock generator comprises a T-coil for generating a quadrature clock signal based on the first clock signal.

5. The device of any one of the claims 1 to 4, wherein
the first lane further comprises a divider configured to generate a third clock signal based on the second clock signal, the third clock being **characterized by** a lower clock frequency relative to the second clock signal.

6. The device of any one of the claims 1 to 5, wherein
the first lane comprises a multiplexer configured to provide a data stream based on the second clock signal and an input data stream;
or wherein
the first lane comprises an analog-to-digital converter configured to provide a data stream based on the second clock signal and an input data stream.

7. The device of any one of the claims 1 to 6, wherein
the plurality of lanes further comprises a second lane configured to provide a second signal pair;
and/or wherein
the circuit is configured to provide clock alignment by aligning phases of outputs of the plurality of lanes.

8. A device comprising:
a controller configured to provide control signals;
a phase-lock loop, PLL, coupled to a first clock generator, the PLL being configured to generate a first clock signal, the first clock signal operating at a first frequency;
a first clock generator configured to generate signal pairs for a plurality of lanes using the first clock signal, a first signal pair being **characterized by** a second frequency, the second frequency of the same as the first frequency;
a phase interpolator being configured to generate a second clock signal based on the signal pairs and the control signals;
a divider configured to generate divided clock signals;
a first multiplexer coupled to the divider, the first multiplexer being configured to provide a first data stream using an input data stream and the divided clock signals; and
a second multiplexer coupled to the phase interpolator and configured to provide a second data stream using the first data stream and the second clock signal.

9. The device of claim 8, wherein
the plurality of lanes comprises four lanes sharing the first clock generator, and each lane comprises its own phase interpolator.

10. The device of claim 8 or 9, further comprising
a synchronization circuit coupled to the divider and configured to provide a feedback signal to the controller;
wherein in particular
the controller is configured to generate the control signals using the feedback signal to adjust the phase interpolator.

11. The device of any one of the claims 8 to 10, wherein
the first multiplexer comprises multiplexers operating at a frequency of the divided clock signals or the second clock signal.

12. The device of any one of the claims 8 to 11, further comprising
a digital-to-analog converter configured to generate analog signals based on the second data stream.

13. A device comprising:
a controller configured to provide control signals;
a phase-locked loop, PLL, configured to generate a first clock signal, the first clock signal operating at a first frequency;
a quadrature clock generator coupled to the PLL, the quadrature clock generator being configured to generate signal pairs;
a dual-phase interpolator configured to receive the signal pairs and the control signals, the dual-phase interpolator being configured to generate phase-adjusted clock signals for the lane in which it is located;
a divider coupled to the dual-phase interpolator, the divider being configured to generate divided clock signals using the phase-adjusted clock signals;
a first multiplexer coupled to the divider, the first multiplexer being configured to provide a first data stream using an input data stream and the divided clock signals; and
a second multiplexer coupled to the phase interpolator and configured to provide a second data stream using the first data stream and the phase-adjusted clock signals.

14. The device of claim 13, wherein
the signal pairs comprise an in-phase signal and a quadrature-phase signal, the signal pairs being **characterized by** a second frequency, the second frequency being of the same as the first frequency;
or wherein
the dual-phase interpolator comprises a first interpolator and a second interpolator operating at a second frequency, the second frequency being a quarter of the reciprocal of a unit interval of the data being transmitted.

15. The device of claim 13 or 14, further comprising
a synchronization circuit coupled to the divider and configured to provide a feedback signal to the controller;
and/or
a digital-to-analog converter coupled to a high-speed multiplexer and configured to generate analog signals based on a serialized high-speed data stream.
